Europäisches Patentamt

European Patent Office

Office européen des brevets

(11) Publication number : **0 569 259 A2**

# EUROPEAN PATENT APPLICATION

(21) Application number : 93303600.6

(22) Date of filing : 10.05.93

(51) Int. Cl.⁵ : **H01L 29/812, H01L 29/20**

(30) Priority : 08.05.92 JP 143418/92

(43) Date of publication of application :
**10.11.93 Bulletin 93/45**

(84) Designated Contracting States :
**DE FR GB**

(71) Applicant : **THE FURUKAWA ELECTRIC CO.,
LTD.**
**6-1, 2-chome, Marunouchi Chiyoda-ku
Tokyo (JP)**

(72) Inventor : **Irikawa, Michinori**
**No.6-3-202, Namiki 2-chome**
**Kanazawa-ku, Yokohama-shi (JP)**
Inventor : **Iga, Kenichi**
**No. 33-10, Tsukushino 2**
**Machida-shi, Tokyo-to (JP)**

(74) Representative : **Gibson, Stewart Harry**
**URQUHART-DYKES & LORD Business
Technology Centre Senghennydd Road
Cardiff CF2 4AY (GB)**

(54) **Multiquantum barrier field effect transistor.**

(57) A field effect transistor having an excellent transfer conductance and an improved gate leakage current and breakdown voltage is provided. In the transistor, a multiquantum barrier gate structure 4 is arranged along a channel layer 3 and having an effect of reflecting incident carriers as waves in with phase conditions capable of allowing mutual enhancement of the incident and reflected waves in a region between a channel layer 3 and a gate electrode 10 and/or in a region opposite to the gate electrode 10 relative to the channel layer 3.

Fig. 1

EP 0 569 259 A2

## BACKGROUND OF THE INVENTION

[Field of the Invention]

This invention relates to a multiquantum barrier transistor having improved and distinguished characteristics.

[Prior Art]

High-electron mobility transistors (HEMTs) are attracting large interest for their excellent functional features such as high operating speed and low power consumption.

An HEMT device having a channel layer of $Ga_{x-}In_{1-x}As$ is expected to have a promising future because of its enhanced mobility in a low electric field, large saturation velocity, large band gap in a heterointerface and other outstanding characteristics in terms of current gain and cut-off frequency. Some of the papers reporting on this type of device include the following:

Paper No. 1: U. Mishra et al., IEEE, EDL, 9.41 (1988)

Paper No. 2: J. Kuang et al., Appl. Phys. Lett. 57, 1785 (1990)

[Problems to be Solved by the Invention]

An HEMT device having a channel layer of $Ga_{x-}In_{1-x}As$ is, however, accompanied by certain problems to be solved as described below.

Firstly, the relationship between the transfer conductance gm and the gate-source voltage Vgs of such a device exhibits a saturation at a certain Vgs(S) and the value of gm tends to decrease in Vgs region larger than Vgs(S).

Secondly, a device under consideration has a low-drain breakdown voltage. Incidentally, an Al-GaAs/GaAs type device has a drain breakdown voltage of 7V, whereas an InGaAs/AlInAs type device shows a drain breakdown voltage of 4 to 6V.

On the other hand, Paper No. 3 as quoted below reports that the gm-Vgs relationship of a GaAs/InGaAs/AlGaAs type device can be improved by increasing the barrier height of AlGaAs, changing Al composition.

Paper No. 3: Col. of Papers for 1992 spr., Ins. of Electronic Information and Telecommunication, 29p-ZP-6 (1992)

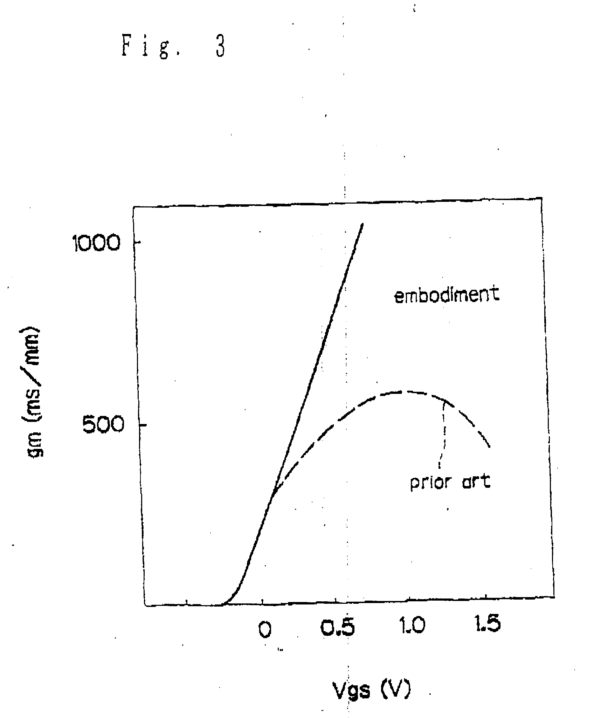

In InGaAs/AlInAs HEMT device, as is clearly shown in Paper No. 2 listed above and in Fig. 3 of the accompanying drawings of this specification, a large gm has been achieved and the breakdown has been improved by arranging its electron supplying layer as a modulation doped structure with a nondoped AlInAs layer and increasing the barrier height of the electron supplying layer. However, the tendency of easy saturation of gm and the tendency of lowering of gm in a large gate-source voltage can not be improved by such an arrangement.

There has been reported in Paper No. 5 as listed below that gm and other characteristics of a device of the type under consideration can be improved by using a GaInAs strained channel layer, lowering the conduction band edge of the channel and raising the heterobarrier height.

All these reports reveal a fact that the intrinsic performances of the device of type under consideration can be improved by increasing the effect of confining two-dimensional electron gas to the channel layer in raising the height of the barrier of the electron supplying layer. However, the conventional technique as described in Paper No. 2 quoted above does not provide any satisfactory improvement because gm tends to be easily saturated.

It is, therefore, an object of the present invention to provide an HEMT which is free from the material restrictions such as the electron affinities and other constants specific to the materials which take part in determining the barrier height of the electron supplying layer and hence is capable of selecting a sufficiently large barrier height so that carriers can be satisfactorily confined to the channel layer and the device can show excellent characteristics in terms of transfer conductance, breakdown voltage and other characteristics.

## SUMMARY OF THE INVENTION

According to the invention, the above object and other objects of the invention are achieved by providing a multiquantum barrier transistor comprising a multiquantum barrier structure arranged along a channel layer and having an effect of reflecting incident carriers as waves in a phase conditions capable of allowing mutual enhancement of the incident and reflected waves in a region between a channel layer and a gate electrode and/or in a region disposed opposite to the gate electrode relative to the channel layer.

The multiquantum barrier structure of a transistor according to the invention preferably comprises a strained superlattice layer.

As is clearly described in Paper No. 4 listed below, a multiquantum barrier (MQB) layer is so designed as to reflect incident carriers as waves in a phase condition capable of allowing mutual enhancement of the incident and reflected waves so that it can have an "effective" barrier height in reflecting incident carriers significantly higher than the the "classic" barrier height.

Paper No. 4: K. Iga et al., Electron. Lett. 22, 1008 (1986)

The present invention consists in applying the above feature of a multiquantum barrier to a field effect transistor. More specifically, the carrier overflow from the channel layer in a transistor of the type under consideration is suppressed by MQB in order to consequently suppress the tendency of saturation of gm in the gm-Vgs relationship and to realize a large gm in a large electric current.

With regard to the drain breakdown voltage, one of the dominant reasons for the noticeably low drain breakdown voltage of a conventional transistor can be attributed to the leakage current given rise to by electrons injected from the gate toward the drain and the channel near the drain, because the potential difference between the gate and the drain is maximized when the gate is biased to lowest voltage to give current-off condition.

According to the invention, such a low drain breakdown voltage due to a leak current can be effectively eliminated by providing the Schottky gate contact layer with an MQB structure with sufficiently high effective barrier height against the gate Schottky metal.

Then, the volume of electrons injected from the gate toward the drain and the channel is significantly reduced to consequently raise the drain breakdown voltage.

Now, the present invention will be described in greater detail by referring to the accompanying drawings that illustrate preferred embodiments of the invention.

## BRIEF DESCRIPTION OF THE INVENTION

Fig. 1 (a) is a schematic cross sectional view of a first embodiment of multiquantum barrier transistor of the present invention.

Fig. 1 (b) is a schematic illustration of the energy bands for conduction band edge of the multiquantum barrier layer of the embodiment of Fig. 1(a).

Fig. 1(c) is a schematic illustration of the energy bands for conduction band edge of the embodiment of Fig. 1(a), when a positive voltage is applied to the gate to give current-on stage.

Fig. 2 is a graph showing the relationship between the energy level of incident electrons and the reflection coefficient of incident electrons for the multiquantum barrier layer of the embodiment of Fig. 1(a).

Fig. 3 is a graph showing the relationship between transconductance gm and gate-source voltage Vgs of the embodiment of Fig. 1(a).

Fig. 4(a) is a schematic sectional view of a third embodiment of multiquantum barrier gate transistor of the present invention.

Fig. 4(b) is a schematic illustration of the structural features of the energy bands for conduction band edge of embodiment of Fig. 4(a).

## DETAILED DESCRIPTION OF THE INVENTION

[Embodiment 1]

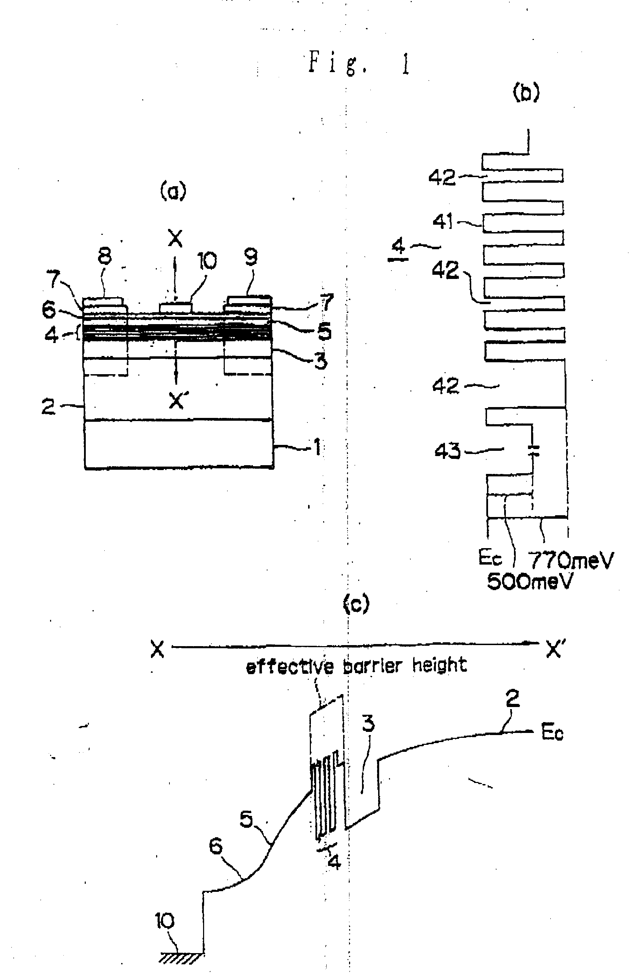

Fig. 1(a) is a schematic sectional view of a first embodiment of multiquantum barrier gate transistor of the present invention, which is in fact an HEMT of an InGaAs/InAlAs system and comprises

a semi-insulating InP substrate 1,

a 300nm thick undoped $Al_xIn_{1-x}As$ (x=0.48) buffer layer 2,

an 80nm thick undoped $Ga_xIn_{1-x}As$ (x=0.47) channel layer 3,

a multiquantum barrier layer 4,

a 30nm thick n+-$Al_xIn_{1-x}As$ (x=0.48) supply layer 5,

a 20nm thick undoped $Al_xIn_{1-x}As$(x=0.48) gate contact layer 6,

a 20nm thick n+-$Ga_xIn_{1-x}As$ (x=0.47) ohmic layer 7,

an AuGe/Ni/Au source electrode 8,

an AuGe/Ni/Au drain electrode 9 and

a TiPt/Au gate electrode 10.

The multiquantum barrier layer 4 of the above embodiment comprises a 6-monolayers (ML) thick undoped $Ga_xIn_{1-x}As$ (x=0.47) well layer 41, an undoped $Al_xIn_{1-x}As$(x=:0.62) barrier layers 42 consisting of six (6) 4-ML thick layers, each having a 1% in-plane tensile strain, and a (1) 15-ML thick layer also having a 1% in-plane tensile strain and a lattice-matched $Al_xIn_{1-x}As$ (x=:0.48) barrier layer 43.

Some of the theoretical aspects and the effects of using a strained superlattice structure in an MQB are disclosed by inventors of this application in Japanese Patent Laid-open Publication No. Hei 5-7051 and Paper No. 5 listed below.

Paper No. 5: M Irikawa et al., Jpn. J.Appl.Phys. 31 (1991) L.1351

The changes of the energy level at the conduction band edge are reported in Paper No. 6 as listed below.

Paper No, 6: F. L. Schuermeyer et al., Appl. Phys. Lett. 55, 1877 (1989)

According to the Paper, and $Al_xIn_{1-x}As$ barrier layer having a 1% tensile strain against InP shows a barrier height conduction band edge discontinuity of approximately 770meV against GaInAs.

The inventor of the present invention calculated the effective barrier height of an MQB having a configuration as illustrated in Fig. 1(b) by using a transfer matrix method (TMM) described in Paper No. 7 as listed below.

Paper No. 7: B. Jonsson et al., IEEE J. Quantum Electron., QE-26, 2025 (1990)

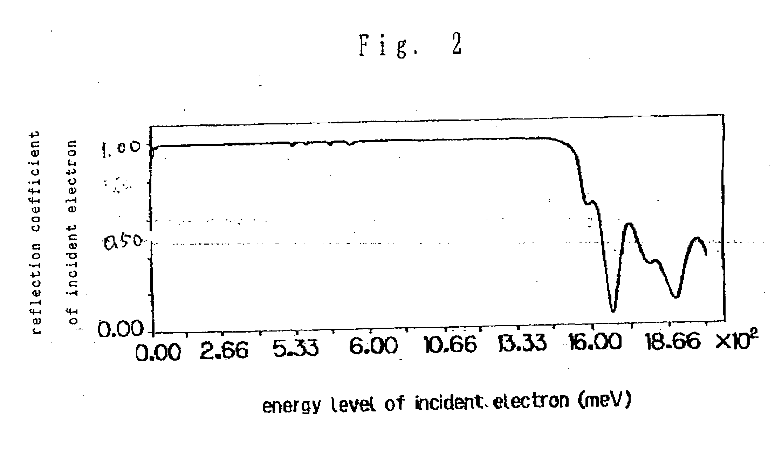

Fig. 2 illustrates the result of the calculation.

Referring to Fig. 2, the effective barrier height of the MQB under consideration is approximately 1,500meV in view of the energy level and the reflection coefficient of incident electrons, showing an increase of 740meV against the actual barrier height 770 meV and proving a barrier height approximately 1.0eV higher than that of lattice-matching AlInAs against GaInAs or 510meV.

Such an enhanced effective barrier height shows a remarkable effect on the leakage current due to overflowing carriers injected from the channel layer to the gate-side electron supplying layer as described below.

Fig. 1(c) schematically illustrates the energy band of the embodiment of Fig. 1(a) observed when a positive voltage is applied to the gate.

The amount of overflowing electrons from the channel layer 3 to the electron supplying layer 5 can be explained by the thermionic emission theory as in the case of injection of electrons from a metal to a semiconductor at a Schottky junction and given by formula (1) below as it may be obvious if Paper No. 8 listed below is referred to.

Paper No. 8: P. Collot et al., Appl, Phys. Lett. 58, 367 (1991)

$$J \propto \exp( - q \, \phi/kT) \quad (1)$$

where $\phi$ is the barrier height.

From the equation (1) above, the leakage current will be reduced by exp(-1000/26)=2x10-17 or 17 figure when compared with that of a conventional structure (lattice-matched AlInAs).

Thus, the tendency of saturation and reduction of gm in the gm-Vgs relationship is suppressed to realized a high gm in a high-electric current as typically shown in Fig. 3.

Consequently, large improvement is expected on the current driving capability and on logic swing for digital applications.

While AlInAs layers having a 1% tensile strain were used for the barrier layers in the above described first embodiment, they may alternatively consist of lattice-matched AlInAs. Similarly, InP or GaInAsP may alternatively be used for the well layers of the embodiment.

As may be obvious from Fig. 1(c), an MQB structure may also be used for the buffer layer side in order to suppress the overflow of electrons to the buffer layer side.

[Embodiment 2]

The second embodiment of the invention is consisting of InGaAs/AlGaAs HEMT and has layers similar to those of the first embodiment but realized by replacing them as described below.

The InP substrate and the undoped $Al_xIn_{1-x}As$ (x=0.48) buffer layer of the first embodiment are respectively replaced by a semi-insulating GaAs layer and an undoped GaAs buffer layer in the second embodiment. The lattice-matched GaInAs channel is replaced by strained $Ga_xIn_{1-x}As$ (x=0.1) channel.

The multiquantum barrier layers of the second embodiment comprises $Al_{0.25}Ga_{0.75}As$ barrier layers of different thicknesses (a(1) 60ML layer, a (1) 15 ML layer, six (6)-4ML layers) and nine (9)-GaAs well layers of 4ML.

The n+-$Al_xIn_{1-x}As$ (x=0.48) supplying layer and the undoped $Al_xIn_{1-x}As$(x=0.48) gate contact layer of the first embodiment are respectively replaced by an n+-GaInP supplying layer and an undoped AlGaAs gate contact layer.

Finally, the n+-$Ga_xIn_{1-x}As$ (x=0.47) ohmic contact layer of the first embodiment is replaced by an n+-GaAs ohmic contact layer in the second embodiment. The layers are arranged in the above-mentioned order.

The second embodiment shows an effect similar to that of the first embodiment.

[Embodiment 3]

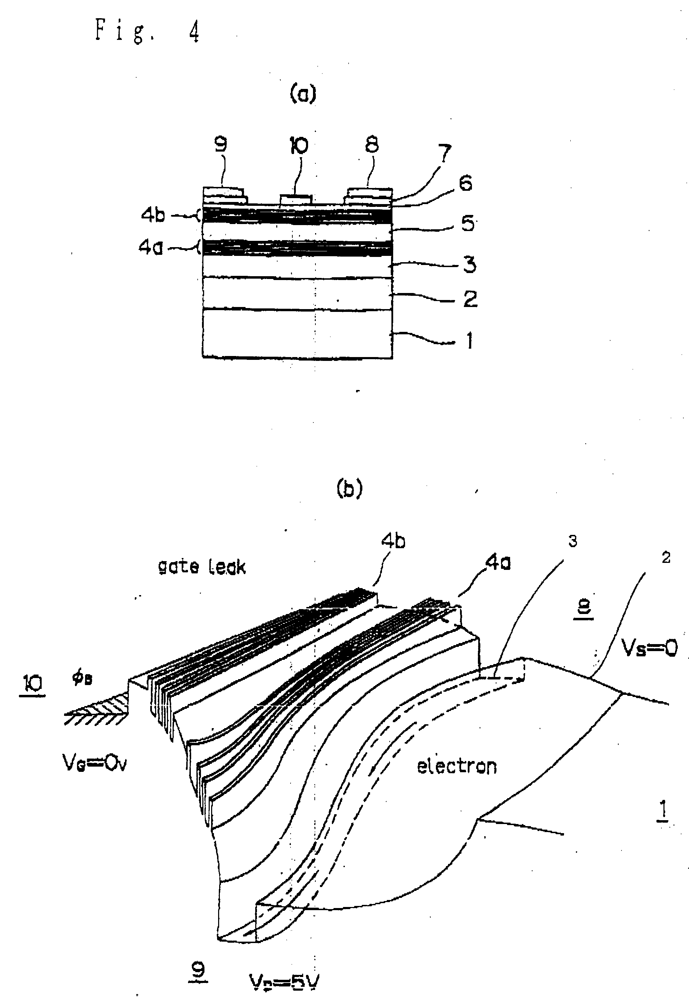

While a third embodiment of the present invention is illustrated in Fig. 4(a). Here, the material system is same as that of the first embodiment. However, two MQBs disposed respectively along the channel 3 and the gate electrode 10.

In the HEMT illustrated in Fig. 4(a), the MQB 4a disposed along the channel 3 reflects carriers overflow from the channel 3 to the gate electrode 10 as was described in the first embodiment. On the other hand, the MQB 4b disposed along the gate electrode 10 reflects electrons injected from the gate to channel near the drain electrode 9 when the gate has a potential close to that of the source.

Fig. 4 (b) is a schematic illustration of the energy band diagram for conduction band edge for the third embodiment.

The function of the second MQB 4b is to realize sufficiently high effective barrier height for the gate Schottky junction, enough to reduce gate leakage current described above.

The theory underlying the use of a second MQB is described in the above cited Japanese Patent Laid-open Publication No. Hei 5-7051.

The concept of the present invention can be applied not only to HEMTs but also to FET, SIS- and MIS-type transistors in the insulating layer of any of them in order to reduce the gate leakage current.

Additionally, the concept of the present invention can be applied not only to field effect transistors consisting of other compound materials than described above, but also to Si/Ge, FET and to any Si-MOSFETs which are accompanied by the problem of injection of hot electrons into the gate insulating layer.

The MQB of a transistor of either of the above cited two types may alternatively comprise an $Si_xGe_{1-x}$/Si strained superlattice layer.

As described above in detail, since a multiquantum barrier transistor according to the invention comprises a multiquantum barrier structure arranged along a channel layer and having an effect of reflecting incident carriers as waves in phase conditions capable of allowing mutual enhancement of the incident and reflected waves in a region between a channel layer and a gate electrode and/or in a region opposite to the gate electrode relative to the channel layer, the overflow of carriers from the channel layer and injection of electrons from the gate metal toward the drain are suppressed to consequently improve the transfer conductance gate leakage current and the breakdown voltage of the transistor.

## Claims

1. A multiquantum barrier transistor comprising multiquantum barrier stricture arranged along channel layer and having an effect of reflecting incident carriers as waves in phase conditions capable of allowing mutual enhancement of the incident and reflected waves in a region between channel layer and a gate electrode and/or in a region opposite to the gate electrode relative to the channel layer.

2. A multiquantum barrier transistor according to claim 1, wherein the multiquantum barrier structure comprises a strained superlattice layer.

Fig. 1

(b)

(a)

X

8    10    9

7

7

6

5

4

3

2

X'

1

42

41

4

42

42

43

Ec    770meV

500meV

(c)

X ——————————————————— X'

effective barrier height

2

——— Ec

3

5

6

4

10

Fig. 2

energy level of incident electron (meV)

reflection coefficient of incident electron

Fig. 3

Fig. 4

(a)

(b)